# EUROPEAN PATENT APPLICATION

(11) **EP 2 124 432 A1**
(43) Date of publication of application: **25.11.2009**
(21) Application number: 08703197.7
(22) Date of filing: 15.01.2008
(51) Int. Cl.: H04N 5/225, H01L 27/14, H04N 5/335

(54) **IMAGING DEVICE AND METHOD FOR MANUFACTURING THE DEVICE**

(30) Priority: 21.02.2007 JP 2007040671
(71) Applicant: Konica Minolta Opto, Inc., Hachioji-shi, Tokyo 192-8505 (JP)
(72) Inventor: SAITO, Masashi, Hachioji-shi Tokyo 192-8505 (JP)
(74) Representative: Henkel, Feiler & Hänzel
(86) International application number: PCT/JP2008/050333
(87) International publication number: WO 2008/102575

(57) **Abstract**

There is provided an imaging device capable of easily shielding an imaging element. The imaging device comprises a conductive mirror frame, an element unit including an imaging element equipped with a photoelectric converter, and an imaging lens attached within the mirror frame and imaging a subject image on the photoelectric converter of the imaging element. The element unit has an exposed conductive member contactable to the mirror frame.

## Description

### FIELD OF THE INVENTION

The present invention relates to an imaging device and, in particular, to a small-sized imaging device suitable to be mounted on a cell-phone and to a manufacturing method for the small-sized imaging device.

### BACKGROUND OF THE INVENTION

The development of a cell-phone carrying a small-sized camera and of a handy personal computer (portable personal computer) has recently been advanced. For example, a cell-phone equipped with a small-sized camera can take an image of a calling party with its onboard small-sized camera to take in as image data, and can transmit the image data to an intended party. The small-sized camera of this kind is generally composed of an image sensor and a lens. Namely, the lens can form an optical image on the image sensor, and the image sensor can generate electric signals corresponding to the optical image.

Meanwhile, a cell-phone and a handy personal computer are in a trend of further downsizing, and small-sized cameras used for them are also requested to be downsized. To meet the demands of downsizing for the small-sized cameras, there has been developed a camera module wherein a lens and an image sensor are integrated.

In traditional methods of manufacturing camera modules, camera modules representing small-sized cameras have been manufactured in many cases by carrying out a series of manufacturing processes including a molding process → an LF etching process → a PKG dicing process → a PKG mounting process → a sensor chip mounting process → a cleaning process → a lens mounting process → a testing process.

In the more specific explanation of the manufacturing process, a mold formed body representing a main body of a camera module is formed first in the molding process by molding a semiconductor chip on a substrate (which is called a lead frame (LF)). In this case, a plurality of mold formed bodies are generally formed in a unified manner for increasing manufacturing efficiency. In the LF etching process, lead frames are removed by etching process, leaving only portions which function as external terminals. Owing to this, a projection-shaped terminal is formed on a bottom surface of the mold formed body. After that, in the package (PKG) dicing process, a plurality of mold formed bodies formed to be linked together are individualized through dicing. Next, in the PKG mounting process, the mold formed body thus individualized is mounted on the flexible substrate, and a sensor chip is mounted on each mold formed body in the sensor chip mounting process. After that, the mold formed body on which a sensor chip is mounted is cleaned, and in the lens mounting process, a lens is mounted on the mold formed body. Finally, the camera module is tested, and manufacture of the camera module is completed.

In the traditional method of manufacturing camera modules, the PKG dicing is conducted immediately after the LF etching, and a mold formed body is individualized, as stated above. Therefore, the sensor chip mounting process, the cleaning process and the lens mounting process are carried out under the condition that the individualized mold formed body (PKG unit) is mounted on a flexible substrate. Namely, the process to mount a sensor chip and the process to mount a lens holder are advanced under the state wherein each of the individualized mold formed bodies is integrated with a flexible substrate to be fixed. Accordingly, the process to mount a sensor chip or a lens holder is conducted for each of the individualized mold formed bodies separately. For this reason, it has been impossible to mount a sensor chip and a lens holder, for plural mold formed bodies collectively, resulting in the problem that manufacturing processes are inefficient. Patent Document 1: Unexamined Japanese Patent Application Publication No. 2004-200965.

### DISCLOSURE OF THE INVENTION

### PROBLEMS TO BE SOLVED BY THE INVENTION

In contrast to this, Patent Document 1 discloses manufacturing of a camera module in the following processes. In the manufacturing process in the prior art of this kind, an image sensor wafer composed of plural image sensor chips arranged and a wafer-shaped lens array wherein plural lenses each being in an image-sensor-chip-size are arranged, are prepared first. After that, the lens array is pasted on a surface of the image sensor wafer. Further, the image sensor chip and the lens array are cut along cutting grooves, so that the image sensor chip and the lens array may be divided into separated camera modules. Thus, it is possible to simplify the manufacturing process.

Meanwhile, an imaging element is easily affected by external noise, and the imaging element needs to be covered by a conductive shield, accordingly. However, there is a problem concerning how to ground the shield. Further, in the camera module in Patent Document 1, electric contact between an imaging element and a substrate is achieved by direct contact by rewiring that penetrates a through hole from the surface to the back. However, in the case of ordinary semiconductor wafers, it is difficult for them to secure necessary strength for connection as a camera module, as they are, because the ordinary semiconductor wafers are easily damaged. In contrast to this, if a thickness of the wafer is increased to secure the strength, it is difficult to make a through hole for wiring, and a yield rate is worsened, resulting in a fear of a cost increase. Further, some lenses in the lens array and some imaging elements in the wafer are sometimes defective, and when one of the lens and the imaging element is defective and the other is non-defective, a camera module obtained by gluing together both of them is defective. Therefore, gluing together them indiscriminately has a problem to worsen yield rate of an imaging device.

The present invention has been achieved in view of the problems in the prior art mentioned above, and its objective is to offer an imaging device that makes it possible to improve yield rate while securing easy manufacturing of the imaging device, and to offer a manufacturing method for the imaging device.

### METHODS TO SOLVE THE PROBLEMS

An imaging device described in Claim 1 has therein a conductive lens barrel, an element unit including an imaging element equipped with a photoelectric converter and an imaging lens, and is **characterized in that** a conductive member capable of touching the lens barrel is exposed from the element unit.

In the invention, the imaging device has a shielding function for the imaging element, and is capable of realizing a compact structure, because the image device has a conductive lens barrel. In addition, since the conductive member is exposed, electric conduction is created by the contact with the conductive member when the conductive lens barrel is mounted on the element unit, and shielding functions of the aforesaid lens barrel are exhibited by grounding wires connected to the conductive member on the base plate.

An imaging device described in Claim 2 is **characterized in that** the aforesaid element unit has a resin plate that has the inserted conductive member and is mounted on the back side of the aforesaid imaging element, and the conductive member is exposed when the resin plate is cut.

In the invention, when the aforesaid resin plate is cut for each imaging element after the conductive member is inserted into the resin plate and the resin plate is mounted on the back side of the imaging element, the conductive member is exposed. Therefore, the conductive lens barrel can be connected electrically with the conductive member.

An imaging device described in Claim 3 is **characterized in that** the aforesaid conductive member exposed from the cut surface is connected to the ground of the imaging device. In the invention, a shielding function by the lens barrel can be exhibited.

An imaging device described in Claim 4 has therein an element unit including an imaging element equipped with a photoelectric converter and a resin plate mounted on the back side of the imaging element and an imaging lens that forms an image of a photographic object on the photoelectric converter of the imaging element, and is **characterized in that** a conductive member that touches a terminal of the imaging element is inserted in the resin plate when the imaging element is mounted.

In general, for boring a through hole on a semiconductor wafer, it is advantageous to make its thickness to be thin. However, when the imaging element is made to be thin, its stiffness is lowered, and it cannot support an imaging lens and a lens barrel. In contrast to this, it is possible to secure high stiffness by forming an element unit wherein the imaging element is lined with the resin plate. However, if the resin plate is mounted on the imaging element, the wiring that is drawn out to the back side through the aforesaid imaging element cannot be connected electrically to the wiring of the base plate, if no actions are taken.

In the invention, it is possible to make the wiring from the imaging element to be connected electrically to the wiring of the base plate through the conductive member, by inserting the conductive member into the inside of the resin plate.

A manufacturing method for an imaging device described in Claim 5 is one for an imaging device having an imaging element equipped with a photoelectric converter and an imaging lens that forms an image of an photographic object on the photoelectric converter of the imaging element, the one being characterized to have a process to form an imaging lens array equipped with plural imaging lenses, a process to form an apparatus assembly by selecting a prescribed imaging lens in the imaging lens array and by gluing the imaging element only to the aforesaid prescribed imaging lens and a process to form an imaging device by cutting and separating the apparatus assembly.

In the traditional technology shown in Patent Document 1, some lenses in the lens array and some imaging elements in the wafer are sometimes defective, and when one side of them is defective, a camera module obtained by pasting both sides together is defective even when the other side is non-defective, and the yield rate is worsened.

In contrast to this, in the invention, it is possible to improve the yield rate, by selecting non-defective articles and defective articles in plural imaging lenses in forming members formed integrally, and by assembling only non-defective imaging elements formed separately with only selected non-defective articles.

### EFFECTS OF THE INVENTION

The invention makes it possible to offer an imaging device that can improve the yield rate while securing easy manufacturing, and to offer a manufacturing method for the imaging device.

### BRIEF DESCRIPTION OF THE DRAWINGS

Fig. 1 is a cross-sectional view of imaging device 50 relating to the present embodiment.
Fig. 2 is an enlarged diagram of the periphery of an imaging lens of the imaging device 50.
   Each of Figs. 3(a)-3(c) is a diagram showing a process to manufacture element units.
Fig. 4 is a diagram viewed in the direction of arrow IV in Fig. 3(c).
Fig. 5 is a cross-sectional view of apparatus assembly ASY showing the selected combination.

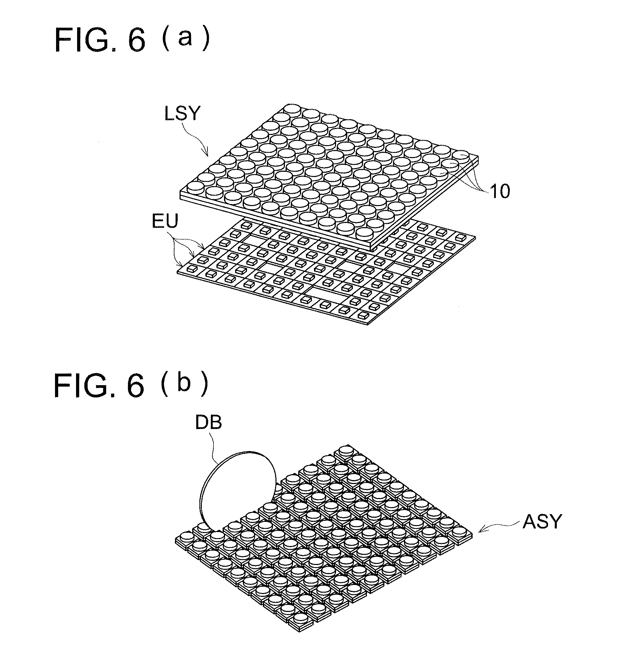

Each of Figs. 6(a) and 6(b) is a perspective view of the apparatus assembly ASY showing the selected combination.

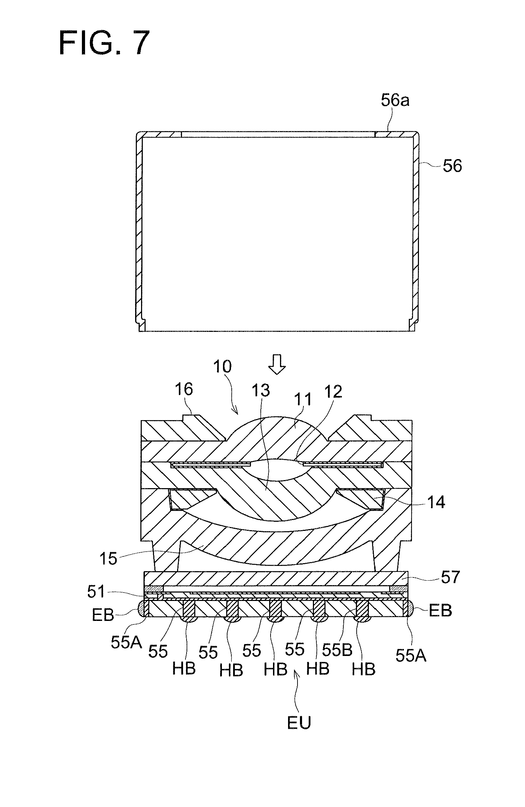

Fig. 7 is a diagram showing a process to fit lens barrel 56 in imaging lens group 10 and in element unit EU for non-defective articles.

### EXPLANATION OF SYMBOLS

10. Imaging lens group
11. Imaging lens
11a. Flange
12. Diaphragm member
13. Imaging lens
13a. Flange
14. Shielding member
15. Imaging lens
15a. Flange
16. Shielding member
50. Imaging device
51. Image sensor
51a. Photoelectric converter
51b. Signal processing circuit section
51c. Through hole
51d. Conductive member
54. Resin plate
55. Conductive member
55A. Conductive member
56. Lens barrel
56a. Flange section
57. Cover glass
ASY. Apparatus assembly
B. Adhesive agent
CG. Cover glass
DB. Dicing blade
EB. Conductive adhesive agent
EU. Element unit
HB. Solder ball
ISW. Image sensor wafer
L1. Wiring layer
L2. Wiring layer
LS1. Imaging lens array
LS2. Imaging lens array
LS3. Imaging lens array
LSY. Lens assembly
RP. Resin plate
S. Aperture stop

### PREFERRED EMBODIMENT OF THE INVENTION

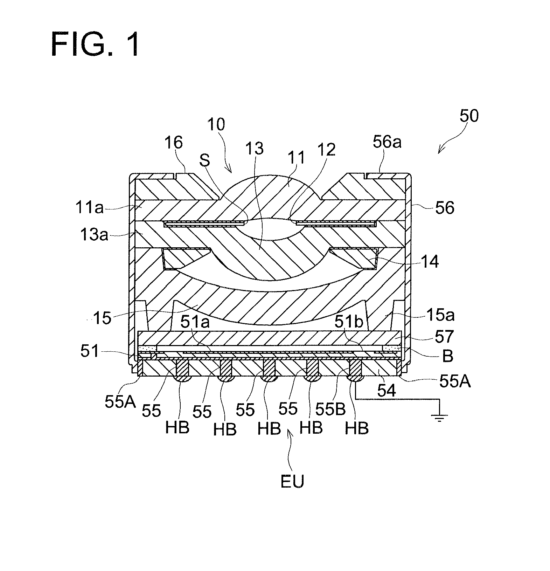

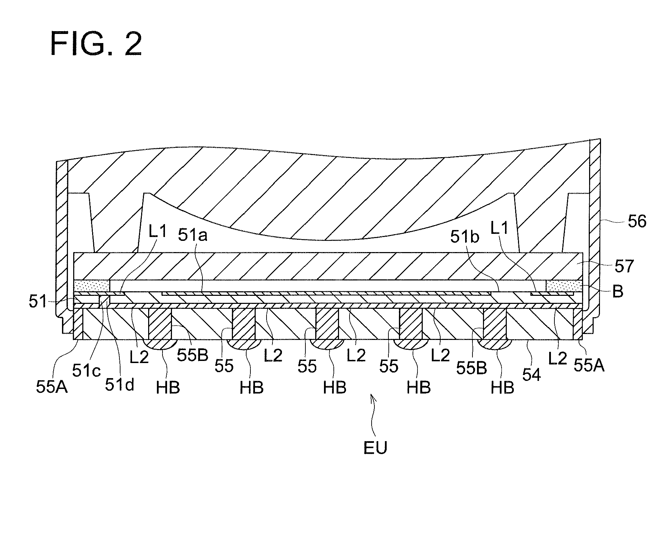

An embodiment of the invention will be explained as follows based on the drawings. Fig. 1 is a cross-sectional view of imaging device 50 relating to the present embodiment. Fig. 2 is an enlarged cross-sectional view of the periphery of an imaging element of the imaging device 50 shown in Fig. 1.

The imaging device 50 has image sensor 51 representing an imaging element. In Fig. 2, photoelectric converter 51a representing a light-receiving section where pixels (photoelectric converting elements) are arranged two-dimensionally is formed at the central portion of a plane on the light-receiving side of the image sensor 51, and on its peripheral, there is formed signal processing circuit section 51b. On the signal processing circuit section 51b of this kind, there are arranged a driving circuit section that drives each pixel successively to obtain signal electric charges, an A/D converting section that converts each signal electric charge into a digital signal and a signal processing section that forms image signal output by using the aforesaid digital signals, although details are not illustrated, and these are arranged so that they can conduct giving and receiving of signals with the outside world.

Further, through hole 51c is formed on a plane (surface) on the light-receiving side of image sensor 51. The image sensor 51 is filed to be in a thickness of about 100 µm, and there is no fear of causing damage when forming the through hole 51c accordingly. A part of wiring layer L1 on the surface side is electrically connected with a part of wiring layer L2 on the back side through conductive member 51d arranged in the through hole 51c.

Resin plate 54 for reinforcement is glued on the back side of the image sensor 51. Plural conductive members 55 are inserted in the resin plate 54 to be formed. An upper end of the conductive members 55 is in contact with wiring layer L2 on the back side of image sensor 51, and a lower end side of the conductive members 55 is in contact with solder ball HB. The solder ball HB passes through a reflow layer at high temperature under the state to be placed on an unillustrated base plate for each imaging device 50, to be melted, thus, electric conduction with the wiring of the base plate is established. Owing to this, the wiring covering from the base plate to image sensor 51 is carried out. The image sensor 51 and resin plate 54 constitute element unit EU.

The image sensor 51 converts signal charges coming from photoelectric converter 51a into image signals such as digital YUV signals, to output them to a prescribed circuit on the base plate through conductive member 55 or the like. In this case, Y represents luminance signals, U (= R - Y) represents color difference signals between red and luminance and V (= B - Y) represents color difference signals between blue and luminance signals. Incidentally, an imaging element is not limited to the aforesaid image sensor of a COMOS type, and other ones such as CCD or the like can be used.

Next, lens barrel 56 and imaging lens 10 will be explained. The lens barrel 56 that is made of conductive member such as iron has flange 56a having on its upper edge a circular inner hole, and the lens barrel is in a shape of a cylinder as a whole, and it stores therein imaging lens group 10. The lower end of the lens barrel 56 is engaged with a side surface of resin plate 54 to be mounted by conductive adhesive agents (which may also be solder). Though the details will be explained later, in this case, conductive member 55A formed through inserting is exposed from the side surface of resin plate 54, to be connected electrically with lens frame 56 engaged with resin plate 54. Meanwhile, the conductive member 55A is connected to the earth ground wiring of an unillustrated base plate through conductive member 55B connected to conductive member 55A through wiring layer L2 provided separately from the conductive member 55A and through solder ball HB touching the conductive member 55B.

In Fig. 1, cover glass (which may also be IR cut filter) 57 is placed over image sensor 51 through adhesive agent B. On the cover glass 57, there is placed imaging lens 15 in a way to hit the cover glass 57 with flange 15a, then on the imaging lens 15, there is placed imaging lens 13 through ring-shaped shielding member 14 in a way to hit the imaging lens 15 with flange 13a, and on the imaging lens 13, there is placed imaging lens 11 through ring-shaped diaphragm member 12 in a way to hit the imaging lens 13 with flange 11a. Ring-shaped shielding member 16 is arranged between flange 11a of the imaging lens 11 and flange section 56a of lens barrel 56. An inside diameter portion of diaphragm member 12 serves as aperture stop S.

By inserting conductive member 55 into resin plate 54 that reinforces thin image sensor 51, in the present embodiment, it is possible to make electric wiring from the image sensor 51 to be connected electrically with electric wiring of a base plate through the conductive member 55. Therefore, an imaging device wherein wiring is not needed and space saving is realized can be offered. Since the grounded conductive member 55A is exposed further from a side face of the resin plate 54 and is connected electrically with lens barrel 56 that is engaged with the resin plate 54, shielding functions of the image sensor 51 can easily be exhibited.

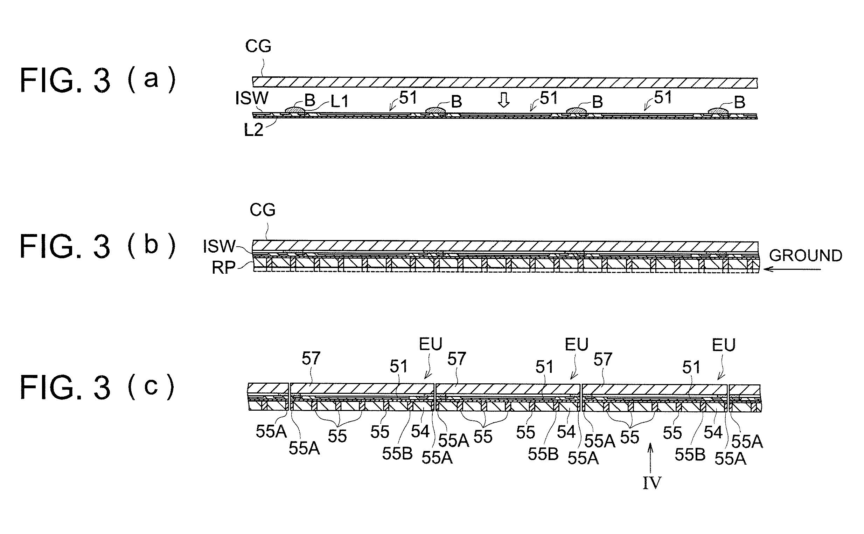

Next, a manufacturing method for the image device relating to the present embodiment will be explained. Figs. 3(a) - 7 are diagrams showing manufacturing processes for imaging device 50. First, let it be assumed that there has already been prepared image sensor wafer ISW that is formed by a wafer process so that plural image sensors 51 and wiring layers L1 and L2 may be arranged in a form of matrixes, is formed.

In this case, large-sized cover glass plate CG in a form of a wafer is arranged to be located above the image sensor wafer ISW, as shown in Fig. 3(a). Then, as shown in Fig. 3(b), resin plate 54 in which a large number of conductive members 55 (including 55A and 55B) are inserted to be formed is connected to the lower part of the image sensor wafer ISW, and a bottom surface of the resin plate 54 is ground until its thickness reaches a prescribed value. At this stage, image sensors 51 are inspected, and non-defective element units EU alone are selected. After that, a glued member is cut by an unillustrated dicing blade, and each element unit EU is formed, as shown in Fig. 3(c).

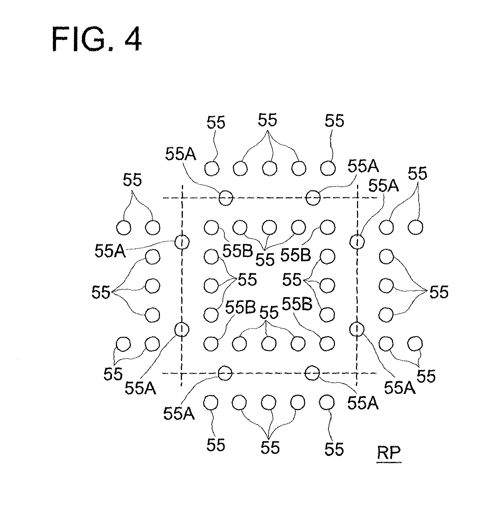

Since conductive member 55A is formed on a boundary of adjoining element units EU, as is shown in Fig. 4 wherein element unit EU in Fig. 3(c) is viewed in the direction of arrow IV, if the element unit EU is cut as shown with dotted lines, conductive member 55A is exposed spontaneously from its cut surface.

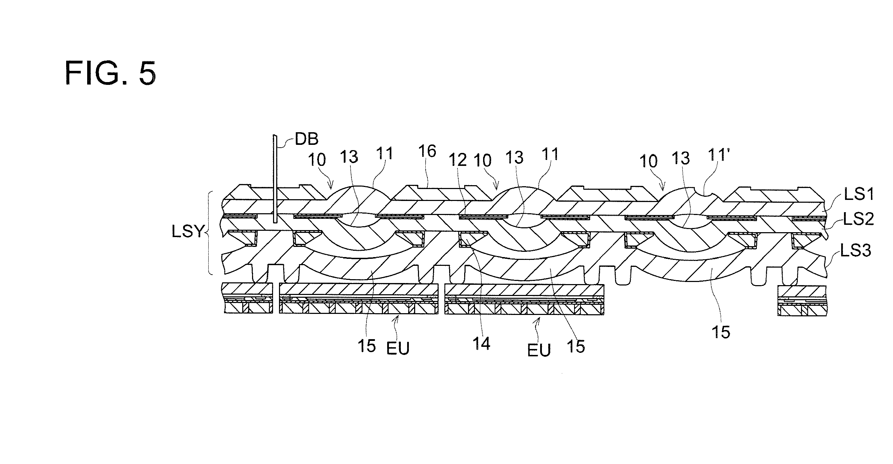

Next, as shown in Fig. 5, imaging lens array LS1 having shielding member 16 and imaging lens 11 formed to be in a matrix shape, imaging lens array LS2 having diaphragm member 12 and imaging lens 13 formed to be in a matrix shape and imaging lens array LS3 having shielding member 14 and imaging lens 15 formed to be in a matrix shape, are superimposed in this order to be stuck with each other, whereby, lens assembly LSY representing a formed member is formed. However, in the lens assembly LSY, imaging lenses are sometimes mixed with defective lenses. Therefore, imaging lenses 11, 13 and 15 are inspected before assembling, to select a combination that is free from any defect. In this particular case, let it be assumed that forming defects were caused on imaging lens 11'.

Further, as shown in Fig. 5 and Fig. 6(a), apparatus assembly ASY is formed at the position corresponding only to the combination of imaging lenses 11, 13 and 15 each having no defects in lens assembly LSY, by arranging the selected element unit EL to be stuck. After that, as shown in Fig. 5 and Fig. 6(b), glued apparatus assembly ASY is cut and separated by dicing blade DB. In this case, an imaging lens group including defective imaging lenses 11' is disposed on a disposal basis or disposed on a recycling basis. However, wastes are less because expensive element units EU are not generally glued on imaging lenses.

It is possible to cause lens barrel 56 to engage with a combination including non-defective imaging lens group 10 and including only non-defective element units EU, allowing the lens side of the aforesaid combination to precede, by doing in the aforesaid manner, and thereby to fix the lens barrel 56 firmly on resin plate 54 to be conductive through conductive adhesive agents EB. After that, the lens barrel 56 is placed on an unillustrated base plate, under the condition that solder balls HB are interposed, corresponding to conductive members 55, to be conveyed to a reflow tank.

As stated above, the invention has been explained, referring to the embodiment. However, the invention should not be construed to be limited to the aforesaid embodiment, and it is naturally possible to vary and improve the embodiment, including changing the imaging lens to a single lens.

## Claims

1. An imaging device having therein a conductive lens barrel, an element unit including an imaging element equipped with a photoelectric converter and an imaging lens that is mounted in the lens barrel, and forms an image of a photographic object on the photoelectric converter of the imaging element, wherein a conductive member capable of touching the lens barrel is exposed at the surface of the element unit.

2. The imaging device described in Claim 1 wherein the element unit has a resin plate that has therein the inserted conductive member and is mounted on the reverse side of the imaging element, and the conductive member appears when the resin plate is cut.

3. The imaging device described in Claim 1 or Claim 2 wherein the conductive member is connected to a ground terminal of the imaging device.

4. An imaging device having therein an element unit including an imaging element equipped with a photoelectric converter and a resin plate mounted on the reverse side of the imaging element and an imaging lens that forms an image of a photographic object on the photoelectric converter of the imaging element, wherein a conductive member that touches a terminal of the imaging element when mounted on the imaging element, is inserted in the resin plate.

5. A manufacturing method for an imaging device including therein an imaging element having a photoelectric converter and an imaging lens that forms an image of a photographic object on the photoelectric converter of the imaging element, wherein there are provided a process to form an imaging lens array equipped with plural imaging lenses mentioned above, a process to select a prescribed imaging lens in the imaging lens array, and to glue the imaging element only to the prescribed imaging lens to form an apparatus assembly and a process to form an imaging device by cutting and separating the aforesaid apparatus assembly.
